# EUROPÄISCHE PATENTSCHRIFT

(11) **EP 3 953 096 B1**
(45) Veröffentlichungstag und Bekanntmachung des Hinweises auf die Patenterteilung: **08.05.2024**
(21) Anmeldenummer: 20716446.8
(22) Anmeldetag: 31.03.2020
(51) Int. Cl.: B23K 20/10, B23K 31/12, B29C 65/08

(54) **VORRICHTUNG UND VERFAHREN ZUM BESTIMMEN EINES ZUSTANDS EINES ULTRASCHALLSCHWEISSPROZESSES**
DEVICE AND METHOD FOR DETERMINING A STATUS OF AN ULTRASONIC WELDING PROCESS
DISPOSITIF ET MÉTHODE POUR DÉTERMINER UN ÉTAT D'UN PROCESSUS DE SOUDAGE PAR ULTRASONS

(30) Priorität: 09.04.2019 DE 102019109262
(43) Veröffentlichungstag der Anmeldung: 16.02.2022
(73) Patentinhaber: Lisa Dräxlmaier GmbH, 84137 Vilsbiburg (DE)
(72) Erfinder: KLIMAS, Felix, 84085 Langquaid (DE); HERZING, Thomas, 84032 Landshut (DE); LEHMANN, Lutz, Landshut 84028 (DE); ZEMANN, Daniel, 84036 Landshut (DE); ERTZ, Gabriel, 30167 Hannover (DE); TWIEFEL, Jens, 30167 Hannover (DE); WALLASCHEK, Jörg, 30167 Hannover (DE); WEINSTEIN, Michael, 30167 Hannover (DE)
(86) Internationale Anmeldenummer: PCT/EP2020/059137
(87) Internationale Veröffentlichungsnummer: WO 2020/207863

(56) Entgegenhaltungen:
- DE-A1-102013 222 876
- US-A1- 2010 280 646
- US-B1- 6 543 668

## Beschreibung

Die Erfindung betrifft eine Vorrichtung zum Bestimmen eines Zustands eines Ultraschallschweißprozesses, eine Anordnung und ein Verfahren.

Ultraschallschweißprozesse von Metallen nutzen Ultraschallwerkzeuge (oder auch US-Schwingsysteme) zum Verschweißen verschiedener Metallpaarungen. Dieser Prozess ist schnell Energieeffizient und zuverlässig.

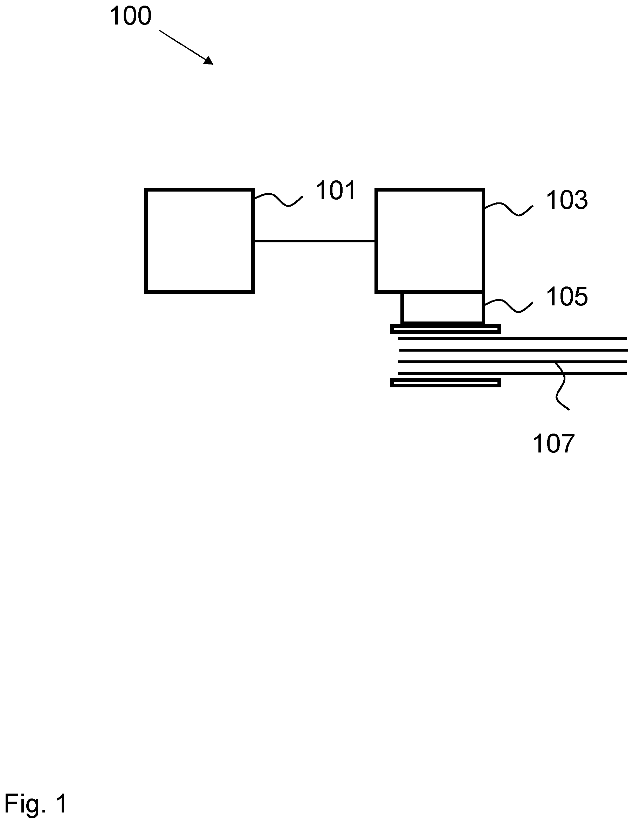

Fig. 1 zeigt eine schematische Darstellung einer Ultraschallschweißanlage 100.

Die Ultraschallschweißanlage 100 umfasst einen Schwingerzeuger 103, d.h. den Konverter einer Sonotrode 105 also dem schwingenden Teil, der mit dem Schweißgut 107 in Kontakt ist und ggf. einem oder mehreren Zwischenstücken, den sogenannten "Boostern", die zur Amplitudentransformation oder der Lagerung dienen. Der Konverter besteht üblicherweise aus einem Stapel piezoelektrischer Aktorkeramiken, die elektrisch kontaktiert sind und über Zusatzbauteile vorgespannt sind.

Ein Generator 101 ist mit dem Konverter verbunden und erzeugt üblicherweise eine sinusförmige Wechselspannung im Ultraschallbereich (20-100 kHz), die von den Piezokeramiken in eine mechanische Schwingung gleicher Frequenz gewandelt werden. Das Design des Konverters, der Booster und der Sonotrode 105 ist so ausgelegt, dass sie nach der Halbwellensynthese auf die vom Generator 101 erzeugte Frequenz abgestimmt sind und sie in bzw. nahe der Resonanz einer Eigenmode schwingen. Im resonanten Zustand lässt sich das gesamte US-Schwingsystem energetisch optimal betreiben.

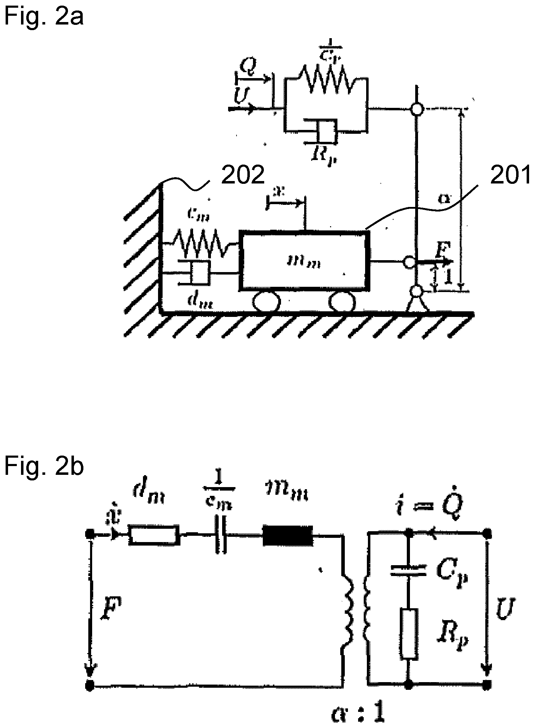

Das elektromechanische US-Schwingsystem kann als mechanisches Ersatzschaubild für den Betrieb in Resonanz dargestellt werden, siehe Fig. 2a, und erlaubt die Ableitung der - zur Charakterisierung des US-Schwingsystems genutzten - Ersatzparameter: ein Wagen 201 mit der Masse mₘ ist über eine Feder cₘ und einen Dämpfer dₘ an die Umgebung gekoppelt. An der rechten Seite greift eine harmonische Kraft F an. Diese Komponenten repräsentieren die mechanischen Komponenten des Ultraschallschwingers, der sich in Resonanz mit der Verschiebung x bewegt.

Hierbei sind die Größen mit dem Index m modale Größen einer angeregten Mode. Über einen Übertrager a ist die mechanische Domäne mit der elektrischen Domäne des Piezoaktors gekoppelt. Hierbei ist Cp die Kapazität des Piezoaktor und Rp repräsentiert den Verlustwiderstand des Piezoaktors, der meist jedoch vernachlässigbar klein ist und vereinfacht als Rp = 0 angenommen werden kann. Die elektrische Spannung U und die Ladung Q sind im mechanischen Ersatzschaubild über den Übertrager a direkt proportional zur mechanischen Kraft F und der mechanischen Verschiebung x.

Somit wird aus dem Schaubild deutlich, dass eine am Piezoaktor angelegte Wechselspannung U(t) zu einer mechanischen Schwingung mit der Verschiebung x(t) führt.

Anstatt der mechanischen Ersatzparameter kann der Ultraschallschwinger mit einer Eigenmode auch in Form eines elektrischen Ersatzschaubilds dargestellt werden, siehe Fig. 2b. Hierbei entspricht die modale Masse mₘ einer Induktivität, der Dämpfer dₘ einem Widerstand, der Übertrager a einem Transformator und die Steifigkeit cₘ dem Kehrwert einer Kapazität. Hierbei wird die Geschwindigkeit der mechanischen Schwingung i als eine elektrische Größe proportional zum Strom ausgedrückt.

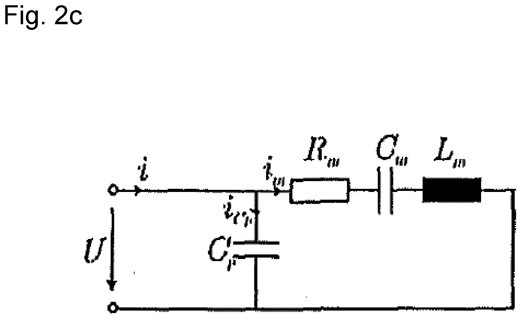

Geht man nun davon aus, dass der Übertragungsfaktor a konstant ist, kann das elektrische Ersatzschaubild weiter vereinfacht werden und durch die Größen Rₘ, Cₘ und Lₘ ausgedrückt werden, siehe Fig. 2c.

Industriell können die elektrischen Ersatzparameter ebenfalls zur Charakterisierung des Schwinggebildes verwendet werden.

Das Schwingsystem wird für den Schweißprozess wie folg genutzt: die oszillierende Bewegung der Sonotrode 105 wird über die Kontaktflächen der Sonotrode 105 auf die zu verschweißenden Fügepartner, d.h. das Schweißgut 107, übertragen. Diese können bspw. ein aus Litzen bestehendes Kabel und ein Kontaktteil sein. Die oszillierende Bewegung der Sonotrode 105 wird an die Litzen weitergeleitet, sodass diese sich relativ zu dem durch einen Niederhalter fixierten Kontaktteil bewegen. Die schnelle Relativbewegung der Fügepartner sorgt zunächst für eine Reinigung der Oberfläche, sodass Oxidschichten abgetragen werden. Durch die Ultraschallschwingung tritt ein beschleunigter Diffusionsprozess zwischen den Prozesspartnern auf, sodass je nach Anwendung innerhalb weniger Sekunden eine kaltverschweißte stoffschlüssige Verbindung der Fügepartner eintritt.

US 6 543 668 B1, die die Grundlage für den Oberbegriff der unabhängigen Ansprüche bildet, zeigt eine Montagevorrichtung eines Flip-Chips mit einer Vielzahl von Höckern, die Bondflächen auf einem Substrat bilden, unter Verwendung von Ultraschallwellen und Thermokompressionsbonden, unter Verwendung eines Flip-Chip-Bondsystems, das die Verbindung einer Vielzahl von Bondflächen eines Flip-Chips überwacht, um eine fehlerfreies Bonden desselben zu gewährleisten, unter anderem umfassend: eine Ultraschallschwingungserzeugungsvorrichtung; ein mit der Ultraschallschwingungserzeugungsvorrichtung verbundenes Horn; ein an dem Horn angebrachtes Spannzangenwerkzeug; eine Steuereinheit; eine mit der Steuereinheit verbundene Substratleiterheizeinheit; und eine Messvorrichtung. Die Messvorrichtung dient der Überwachung der Spannung und/ oder der Stromstärke, der/die an der Ultraschallschwingungserzeugungsvorrichtung anliegen. Durch einen Vergleich der gemessenen Spannung und/oder Stromstärke mit Referenzverläufen wird die Ultraschall- und Thermokompressionsbondverbindung geprüft.

DE 10 2013 222 876 A1 zeigt ein Vibrationsschweißsystem umfassend eine Vibrationsschweißeinrichtung mit einem Schweißhorn und -amboss, eine Host-Vorrichtung, eine Kontrollstation und einen Roboter. Der Roboter bewegt das Horn und den Amboss über einen Arm zu der Kontrollstation. Sensoren, z. B. Temperatursensoren, sind in Bezug auf die Schweißeinrichtung positioniert. Zusätzliche Sensoren sind in Bezug auf die Kontrollstation positioniert und umfassen eine druckempfindliche Anordnung. Die Host-Vorrichtung, welche einen Zustand der Schweißeinrichtung überwacht, misst Signale über die Sensoren, die in Bezug auf die Schweißeinrichtung positioniert sind, wenn das Horn aktiv eine Schweißnaht bildet. Der Roboter bewegt das Horn und den Amboss zu der Kontrollstation, aktiviert die Kontrollstation-Sensoren an der Kontrollstation und bestimmt einen Zustand der Schweißeinrichtung durch Verarbeiten der empfangenen Signale. Es können akustische, Kraft-, Temperatur-, Weg-, Amplituden- und/oder Lage/gyroskopische Sensoren verwendet werden.

US 2010/280646 A1 zeigt ein Verfahren nebst korrespondierender Vorrichtung zur Qualitätskontrolle beim Ultraschallbonden, bei dem eine Transducer-Bondwerkzeugeinheit und ein Ultraschallgenerator verwendet werden und bei dem während des Bondens ein oder mehrere Sensoren zur Erfassung von Messsignalen für einen oder mehrere Parameter, die sich während des Bondens ändern können, zur Beurteilung der Bondqualität und/oder zur Beeinflussung des Bondens verwendet werden. Während des Bondens wird mindestens ein Geschwindigkeitsprofil-Messsignal erfasst, das das Zeit/Geschwindigkeitsprofil der Spitze des Ultraschallwerkzeugs in dessen Schwingungsrichtung darstellt.

Es ist eine Aufgabe der Erfindung ein vorteilhaftes Konzept zum Bestimmen eines Zustands eines Ultraschallschweißprozesses zu beschreiben.

Während des Schweißprozesses gibt es verschiedene Phasen von Reinigungs-, Diffusions- und Verbindungsprozessen, die sich beispielsweise über Impedanz-, Klirrfaktor- oder Anteil bestimmter höherharmonischen Frequenzanteilsverläufe beurteilen lassen. Hieraus lassen sich Indikatoren ableiten, die zur Beurteilung der Prozessqualität genutzt werden können. Die Aufgabe wird gemäß einem ersten Aspekt durch eine Vorrichtung zum Bestimmen eines Zustands eines Ultraschallschweißprozesses gemäß Anspruch 1 gelöst.

Der Referenzsignalverlauf kann in einem Speicher vorgespeichert sein. Die Auswerteeinheit kann eingerichtet sein, den Referenzsignalverlauf aus dem Speicher auszulesen.

Das elektrische Ansteuersignal dient der Ansteuerung des Ultraschallwerkzeugs, um den Ultraschallschweißprozess auszuführen. Durch das Ansteuersignal kann ein Generator das Ultraschallwerkzeug ansteuern.

Die Erfindung betrifft demnach ein systemunabhängiges Anlagen- und Prozessdiagnosesystem für Ultraschallprozesse, das Anlagenunabhängig betrieben werden kann und für den Generator aus elektrischer Sicht "unsichtbar" ist. Dies ermöglicht sowohl eine Charakterisierung des Schwingsystems als auch eine Beurteilung des Schweißprozesses ohne in den Schweißprozess einzugreifen zu müssen und dies unabhängig vom Anlagentyp durchführen zu können.

Eine Funktion ist die Beobachtung des Prozesses und die Erfassung der elektrischen Klemmgrößen Strom und Spannung, die am Ultraschallschwinger während der Schweißung anliegen, ohne dabei die Schweißung zu beeinflussen. Das System ist während der Schweißung für den Generator unsichtbar.

Die beim Messen des elektrischen Ansteuersignals gemessene Messgröße kann eine von der Zeit abhängige Variable sein. Da sich oft unter unterschiedlichen Bedingungen durchgeführte Schweißungen nicht wesentlich in ihrem Durchschnittswert oder einer einzelnen Fouriertransformation über den gesamten Schweißprozess unterscheiden, sondern nur in der Form ihrer Kurve, wenn die physikalischen Größen gegen die Zeit aufgetragen werden, ist es vorteilhaft, die Messgröße zeitabhängig zu erfassen.

Die Anwendung einer Fourieranalyse kann ein Anwenden einer Kurzzeit-Fourieranalyse umfassen, aus der die zeitliche Abhängigkeit der Amplitude, Frequenz oder anderer Größen bestimmt werden kann. Einzelne Fensterabschnitte der Kurzzeit-Fourieranalyse können auf eine geeignete Fensterfunktion zurückzugreifen, insbesondere bei der Berechnung einer Amplitude ein Flattop-Fenster, bei der Berechnung einer Frequenz oder einer Phase ein Rechteckfenster sein. Zeropadding und Interpolation können ebenso angewendet werden, insbesondere bei der Berechnung einer Frequenz bei einer Kurzzeit-Fourieranalyse mit kleinen Fenstergrößen.

Erfindungsgemäß umfasst die Vorrichtung einen ersten Anschluss, der eingerichtet ist, mit einem Ausgang eines Ultraschallgenerators verbunden zu werden; einen zweiten Anschluss, der eingerichtet ist, mit einem Signaleingang des Ultraschallwerkzeug verbunden zu werden, einen Signalpfad, der den ersten Anschluss und den zweiten Anschluss elektrisch verbindet; wobei die Sensoreinrichtung eingerichtet ist, das elektrische Ansteuersignal an dem Signalpfad nichtinvasiv zu messen.

Dies kann ein intelligentes Zwischenschaltsystem darstellen. Dies wird zwischen Generator und Konverter implementiert und beinhaltet Sensorik zur Strom- und Spannungsmessung.

In welcher Intensitätsverteilung die verschiedenen Harmonischen in einer der gemessenen Schwingungen auftreten, kann durch die Kurvenkenngrößen Klirrfaktor, Formfaktor und Scheitelfaktor beschrieben werden. Diese charakterisieren allesamt die Kurvenform einer Wechselgröße.

Ultraschallschweißanlagen nutzen häufig die Frequenz als Stellgröße ihres Regelkreises. Diese wird derart verstellt, dass die Regelgröße konstant gehalten oder während dem Prozess gezielt verändert wird. Typische Regelgrößen sind die ins System eingebrachte Wirkleistung, Auslenkung der Sonotrode bzw. Kernadmittanz (aus den elektrischen Größen abgeschätzt) oder die Phasendifferenz zwischen Strom und Spannung. Diese Regelung ist dafür verantwortlich, dass im Beispiel der reibungsmindernden Verunreinigung durch Fette, beispielsweise Handcreme, die Betriebsfrequenz vom Generator auf einen niedrigeren Wert gestellt wird, als bei sauberen Proben. Um nachzuvollziehen, welchen Effekt bestimmte Schweißeinstellungen und Schweißbedingungen auf die Stellgröße Frequenz haben, kann man sich den Frequenzgang der Admittanz und der Kernadmittanz ansehen. Durch geringere Reibung in der Fügezone, wird die Resonanz (vom mechanischen Serienschwingkreis bestimmt) zu niedrigeren Frequenzen verschoben. Wenn der Startwert der Frequenz oberhalb der Resonanz liegt muss deshalb die Frequenz bei derartig verunreinigten Fügeteilen zu niedrigeren Werten verstellt werden als bei unpräparierten, um Auslenkung an denselben Sollwert zu regeln.

Die Auslenkung an der Sonotrode muss beim Regeln der Anlage nicht in den Regelkreis miteinbezogen werden. Beim Regeln der Auslenkung an einen Sollwert kann diese über die elektrischen Größen abgeschätzt werden. Erfolgt zusätzlich zu den elektrischen Größen auch eine Messung der mechanischen Größen, lassen sich domänenübergreifende Größen wie die Kernadmittanz berechnen. Der Betrag der Kernadmittanz ergibt sich aus Geschwindigkeitsamplitude / Spannungsamplitude. Für die Bestimmung von dessen Phase kann eine Synchronisation der elektrischen und mechanischen Messung notwendig sein.

In einer Ausgestaltung umfasst die Sensoreinrichtung einen Spannungsabtastkopf, um ein Spannungssignal zu messen und/oder einen Stromwandler umfasst, um ein Stromsignal zu messen.

Erfindungsgemäß umfasst die Vorrichtung ein Schaltelement, das in dem Signalpfad angeordnet ist und eingerichtet ist, den Signalpfad zu unterbrechen, um den ersten Anschluss von dem zweiten Anschluss elektrisch zu trennen, und einen Signalgeber, der eingerichtet ist, ein Steuersignal für das Ultraschallwerkzeug zu erzeugen und das Ultraschallwerkzeug anzusteuern, wenn das Schaltelement den Signalpfad unterbricht.

Der Signalgeber kann eine Kleinsignal-Frequenzgeneratoreinheit mit integriertem Verstärker sein. Das Schaltelement kann ein Relais sein.

Eine weitere Funktion der Vorrichtung ist, dass eine, zwischen den Schweißungen, im Ruhezustand des Schweißsystems, stattfindende Kleinsignalansteuerung des Ultraschallschwingers erfolgen kann, während der ebenfalls die elektrischen Klemmgrößen Strom und Spannung gemessen werden (Impedanzmessung). Aus der Impedanzmessung können die Ersatzparameter bestimmt und zur US-Schwinger-Charakterisierung genutzt werden. Die Kleinsignalansteuerung zur Impedanzmessung kann als modifizierte Sinuswelle (auch "Frequenzsweep" genannt) mit einer Frequenz zwischen ± 2 kHz der Betriebsfrequenz ausgeführt sein. Während der Kleinsignalansteuerung ist der Ultraschallschwinger über eine Relais-Schaltung vom Generator entkoppelt und mit einem im Zwischenschaltsystem integrierten Verstärker gekoppelt.

Die direkte Analyse des Anlagenzustands erfolgt durch eine Messung des Frequenzganges der Admittanz. Hierbei wird das unbelastete Schwingsystem mit einer konstanten Spannung bei verschiedenen Frequenzen angeregt und die Systemantwort in Gestalt des Stromes (also durch einen Kleinspannungs-Sweep die frequenzabhängige Admittanz des Piezoaktors mit dem Schwingsystem als Last) gemessen. Aus dem Verhältnis von Stromantwort und Spannung resultiert die frequenzabhängige Admittanz des unbelasteten Schwingsystems. Mit diesem Frequenzgang lässt sich der Zustand des Schwingsystems charakterisieren. Da sich das Schwingsystem aus einem parallelen und einem Serienschwingkreis zusammensetzt, tritt im Bereich der Betriebsfrequenz eine Resonanz und eine Antiresonanz auf. Die Frequenzen, wo diese auftreten, deren Abstand, deren Breite und Betrag, die Phase im Frequenzbereich zwischen ihnen - all diese Größen geben Auskunft über den Zustand des Schwingsystems. Ein defekter Piezoaktor besitzt zum Beispiel einen geringeren Frequenzabstand zwischen Resonanz und eine Antiresonanz. Ein ungeeignet gelagertes System erfährt zum Beispiel Reibungsverluste, die im Frequenzgang erkennbar sind.

In einer Ausgestaltung ist das Schaltelement eingerichtet, den Signalpfad zu unterbrechen, wenn die Sensorvorrichtung erfasst, dass der Ultraschallgenerator kein Steuersignal an das Ultraschallwerkzeug sendet. Somit kann in den Pausen der Ansteuerung eine weitere Messung mit dem Signalgeber als Ultraschallquelle erfolgen.

In einer Ausgestaltung ist der Signalgeber eingerichtet, das Steuersignal für das Ultraschallwerkzeug mittels einer Kleinsignalsteuerung zu erzeugen. Die Berechnung der notwendigen Parameter kann mittels einer Kleinsignalsteuerung vereinfacht erfolgen.

In einer Ausgestaltung ist die Sensorvorrichtung eingerichtet, ein elektrisches Signal an dem Signalpfad zu messen, während der Signalgeber der Vorrichtung über den Signalpfad das Ultraschallwerkzeug ansteuert. Dies kann zur Gewinnung eines Referenzverlaufs beitragen, da der Signalgeber vordefinierte Werte bereitstellen kann.

In einer Ausgestaltung ist die Auswertevorrichtung eingerichtet, basierend auf dem gemessenen elektrischen Signal, das gemessen wurde, während der Signalgeber der Vorrichtung über den Signalpfad das Ultraschallwerkzeug ansteuert, Ersatzparameter zu bestimmen. Dies kann eine Aktualisierung des Modells mittels der Kleinsignalsteuerung bewirken.

Das Schwingsystem lässt sich durch ein elektromechanisches Ersatzschaltbild modellieren. Durch Vergleich der Systemantwort dieses Ersatzschaltbildes mit dem gemessenen Frequenzgang lassen sich die Ersatzparameter des Schaltbildes bestimmen. Mit einem Modell aus vier Ersatzparametern kann der Frequenzgang von Ultraschallschweißanlagen sehr gut approximiert werden. Die Parameter sind: Kapazität des Piezoaktors, Kapazität, Induktivität und Widerstand des mechanischen Schwingers (hier werden die mechanischen Parameter Trägheit, Steifigkeit und Dämpfung in die analogen elektrischen Parameter Kapazität, Induktivität und Widerstand umgewandelt, wie sie in die Impedanz eingehen, die die Last des Generators beschreibt). Mit diesem Verfahren sind Veränderungen des Schwingsystems, vor allem schleichende Veränderungen des Piezoaktors detektierbar.

Es kann auch eine Berechnung dieser Ersatzparameter für den Fall eines belasteten Schwingsystems erfolgen, d.h. wenn die Sonotrode mit einer Normalkraft auf die Fügeteile gepresst wird und damit zusätzliche Dämpfung erfährt. Es ist auch möglich, einen Frequenzgang während des Schweißprozesses zu messen, indem die anregende Spannung deutlich kleiner als die Schweißspannung, die sich im kilo-Volt-Bereich befindet, ist, und damit den Schweißprozess nicht stört, sondern nur überlagert. Sofern die momentane Frequenz der Frequenzgangmessung nicht zu nahe bei der momentanen Betriebsfrequenz ist, lässt sich bei der Strommessung der Anteil der momentanen Frequenz der Frequenzgangmessung herausfiltern. Hierbei kann sich die Auswerteeinrichtung einer Fourieranalyse bedienen.

In einer Ausgestaltung ist der Signalgeber eingerichtet, das Steuersignal basierend auf einem Betriebssignal des Ultraschallgenerators zu erzeugen, insbesondere mit einer Frequenz zwischen ± 2 kHz der Betriebsfrequenz des Ultraschallgenerators.

In einer Ausgestaltung umfasst die Vorrichtung ein Entladungsschaltelement, das an dem Signalpfad elektrisch angeschlossen und eingerichtet ist, in einem leitenden Zustand das Ultraschallwerkzeug kurzzuschließen, so dass eine Restladung im Ultraschallwerkzeug abfließen kann.

Gemäß einem zweiten Aspekt wird die Aufgabe durch Anordnung mit einer Ultraschallschweißanlage und einer Vorrichtung nach dem ersten Aspekt gelöst, wobei die Vorrichtung zwischen einem Ultraschallgenerator der Ultraschallschweißanlage und einem Konverter der Ultraschallschweißanlage angeschlossen ist.

Gemäß einem dritten Aspekt wird die Aufgabe durch ein Verfahren zum Bestimmen eines Zustands eines Ultraschallschweißprozesses gemäß Anspruch 10 gelöst.

In einer Ausgestaltung wird wobei das Messen während eines Schweißprozesses ausgeführt. Dies kann eine Überwachung des Schweißprozesses ermöglichen.

Erfindungsgemäß umfasst das Verfahren ein Trennen eines Ultraschallgenerators von dem Ultraschallwerkzeug durch ein Schaltelement.

Erfindungsgemäß umfasst das Verfahren ein Erzeugen eines Steuersignals durch einen Signalgeber und Ansteuern des Ultraschallwerkzeugs, wenn der Ultraschallgenerator von dem Ultraschallwerkzeug getrennt ist.

In einer Ausgestaltung umfasst das Verfahren ein Bestimmen eines Ersatzparameters für die Schweißanlage basierend auf einem bestimmten Zustand des Ultraschallschweißprozesses basierend auf dem erzeugten Steuersignal.

Auf diese Weise können Referenzwerte zur Bestimmung der gemessenen Kurven erzeugt werden und ein Modell verbessert werden, nach dem der Signalgeber und die Auswerteeinrichtung arbeiten.

Die Erfindung wird im Folgenden anhand von Figuren und Ausführungsbeispielen näher beschrieben. Es zeigen:
- Fig. 1: eine schematische Darstellung einer Ultraschallschweißanlage;
- Fig. 2a: ein mechanisches Ersatzschaltbild einer Ultraschallschweißanlage;
- Fig. 2b: ein elektrisches Ersatzschaltbild des mechanisches Ersatzschaltbilds aus Fig. 2a;
- Fig. 2c: ein elektrisches Kleinsignalersatzschaltbild des mechanisches Ersatzschaltbilds aus Fig. 2a;
- Fig. 3: eine schematische Darstellung einer Ultraschallschweißanlage gemäß einem Ausführungsbeispiel; und
- Fig. 4: ein Flussdiagramm für ein Verfahren gemäß einem Ausführungsbeispiel.

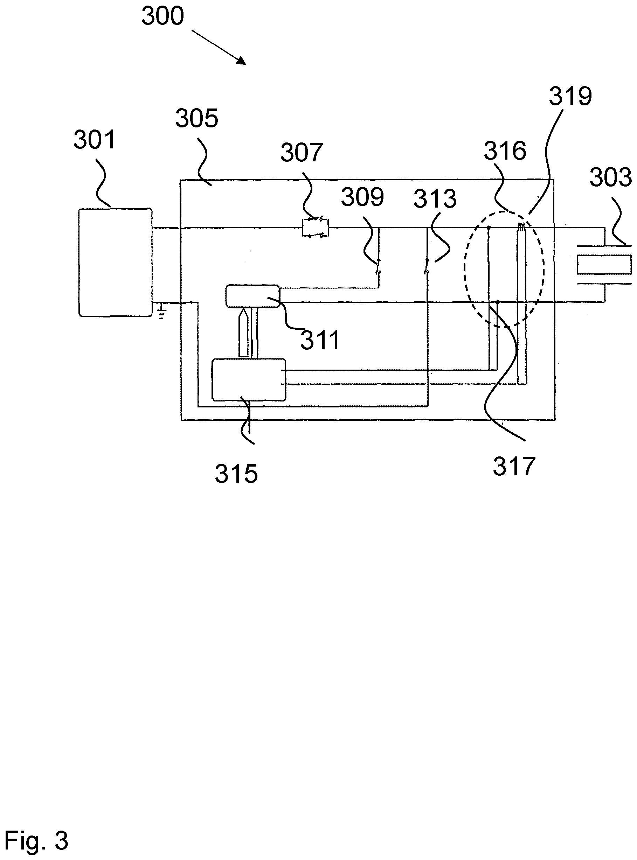

Fig. 3 zeigt schematische Darstellung einer Ultraschallschweißanlage 300 gemäß einem Ausführungsbeispiel. Die Ultraschallschweißanlage 300 umfasst einen Ultraschallgenerator 301 und ein Ultraschallwerkzeug 303. Zwischen den Ultraschallgenerator 301 und das Ultraschallwerkzeug 303 ist eine Vorrichtung 305 geschaltet. Die Vorrichtung 305 umfasst eine Relaisschaltung mit einem Schaltelement 307 zum Trennen eines positiven Pfads zwischen dem Ultraschallgenerator 301 und dem Ultraschallwerkzeug 303.

Die direkte Analyse erfordert eine Vorrichtung 305, die neben dem Ultraschallgenerator 301 eine zusätzliche Spannungsquelle besitzt, die die Spannung für den Frequenzgang bereitstellt (Sweep). Um den Piezoaktor getrennt vom Ultraschallgenerator 301 anregen zu können sind außerdem Hochspannungsrelais als Schaltung erforderlich. Um eine solche Überwachung in der Fertigung nutzen zu können, muss die Vorrichtung in der Lage sein, das Intervall zwischen den Schweißungen zu erkennen, um zum geeigneten Zeitpunkt die Messung durchzuführen, indem dafür die Verbindung zwischen Ultraschallgenerator 301 und Piezoaktor getrennt wird, und der Piezoaktor stattdessen mit der Spannungsquelle der Vorrichtung angeregt wird. In einer anderen Ausführungsform kann das System in den Steuerungs- und Regelungskreis des Generators integriert werden.

Über ein Relais 309 ist ein Signalgeber 311 zuschaltbar, der ein Steuersignal für das Ultraschallwerkzeug 303 erzeugen kann. Die Erzeugung basiert hierbei auf einem Kleinsignal-Ersatzmodell.

Durch die Relaisschaltung kann entweder der Ultraschallgenerator 301 mit dem Schwingsystem oder der Signalgeber 311, hier ein Verstärker des Analysesystems, mit dem Schwingsystem gekoppelt werden. Dies geschieht indem der Pluspol der Leitung, d.h. der Signalpfad, getrennt und mit den verschiedenen Relais-Schaltern verbunden wird.

In einem weiteren Ausführungsbeispiel kann das Schwingsystem zwischen den Schaltvorgängen, die das Schwingsystem mit dem Ultraschallgenerator 301 oder dem Signalgeber 311 verbinden, durch das Schließen eines Entladungsschaltelements 313 für einige Millisekunden kurzgeschlossen werden, sodass vorhandene Restladung, die sich im Ultraschallwerkzeug 303 befindet, abfließen kann, Dies verhindert kurzzeitige Stromspitzen am Ultraschallgenerator 301 und der Kleinsignalansteuerung sobald diese wieder mit dem Schwingsystem verbunden werden.

Die Relaisschaltung sowie der modifizierte Sinus werden softwareseitig angesteuert bzw. erzeugt. Die Zeitpunkte für die Schaltung der jeweiligen Schaltelemente 307, 309, 313 der Relaisschaltung erfolgt über eine Beobachtung des Prozesses. Der Ausgangszustand ist das Beobachten der Schweißungen. Hierzu sind die - je nach benötigter Leistung auch mehrere parallel geschaltete - Schaltelemente geschlossen, sodass der Ultraschallgenerator 301 mit dem Ultraschallwerkzeug 303 verbunden ist.

Beginnt die Schweißung, wird ein Trigger aktiviert, und die Software erkennt Start und Ende der Schweißung und speichert die gemessenen Spannungs- und Stromverläufe für die anschließende Auswertung. Nach abgeschlossener Schweißung wird die Prozesspause genutzt und die Software schaltet von "Generator-Ultraschallschwinger" über "Kurzschluss-Ultraschallschwinger" zu "Kleinsignal-Ultraschallschwinger". Das heißt, das Schaltelement 307 trennt den Signalpfad, das Schaltelement 313 erzeugt für kurze Zeit einen Kurschluss, um Restladung abfließen zu lassen und öffnet sich dann wieder und das Schaltelement 309 schaltet dann den Signalgeber 311 zu, sodass dieser Steuersignal für das Ultraschallwerkzeug 303 bereitstellen kann.

Nun wird der modifizierte Sinus durch den Signalgeber 311 auf das Ultraschallwerkzeug 303 aufgeprägt, wobei die Dauer je nach Prozesspausen wenige Sekunden bis unter 1 Sekunde beträgt. Nach Beendigung der Impedanzmessung schaltet die Software in umgekehrter Reihenfolge die Schaltelemente 309, 313, 307 wieder in den Ausgangszustand und verbindet den Ultraschallgenerator 301 mit dem Ultraschallwerkzeug 303.

Die Umschaltung und Auswertung findet in einer Auswerteeinrichtung 315 statt, hier ein Mikrocontroller. Die Messung des elektrischen Ansteuersignals, egal ob dieses von dem Ultraschallgenerator 301 oder dem Signalgeber 311 kommt, erfolgt über eine Sensoreinrichtung 316, die einen Spannungsmesser 317, insbesondere einen Spannungsabtastkopf, und einen Stromwandler 319 umfasst, der eine nichtinvasive Strommessung ermöglicht.

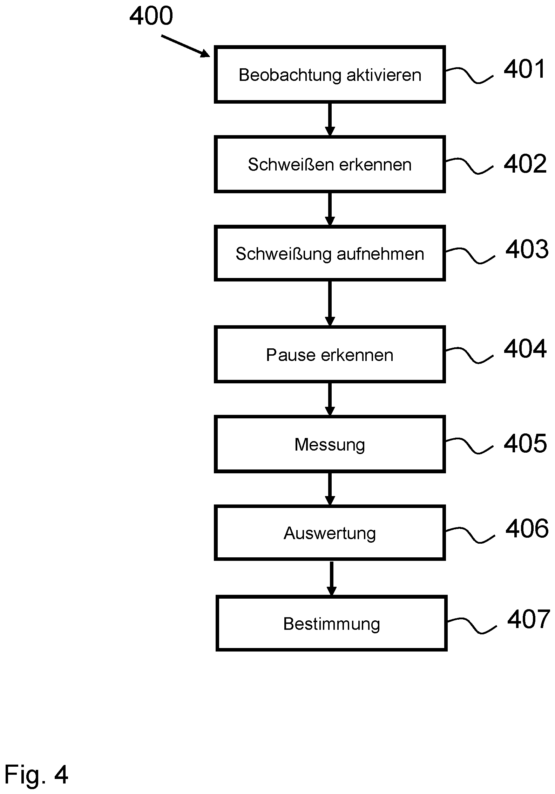

Fig. 4 zeigt ein Flussdiagramm 400 für ein Verfahren gemäß einem Ausführungsbeispiel.

In einem ersten Schritt 401 wird ein transparenter Beobachtermodus eingenommen. Das heißt, das Schaltelement 307 wird so geschaltet, dass der Ultraschallgenerator 301 das elektrische Ansteuersignal für das Ultraschallwerkzeug 303 bereitstellen kann.

In einem zweiten Schritt 402 wird auf eine Schweißung getriggert, d.h. die Auswerteeinheit erkennt, dass eine Schweißung stattfindet. Dies kann durch eine Überwachung des Spanungsmessers 317 erfolgen.

In einem Schritt 403 wird die Schweißung aufgenommen. Hierbei wird nichtinvasiv der Schweißprozess beobachtet. Hierzu wird ein Strom über den Wandler 319 und die Spannung an dem Spannungsmesser 317 gemessen.

In Schritt 404 wird eine Pause des Schweißprozesses, wie zu Schritt 402 beschrieben erkannt.

In Schritt 405 wird anschließend eine Impedanzmessung durchgeführt, und anschließend zurück zum transparenten Beobachtermodus gewechselt, um die Schweißung nicht zu behindern.

Parallel hierzu wird im Schritt 406 das gemessene Ergebnis der Impedanzmessung ausgewertet und so eine Signaleigenschaft ermittelt. Hierbei bestimmt die Auswerteeinheit 315 eine Ableitung von Indikatoren zur Beurteilung der Schweißqualität, Ersatzparameter und stellt eine Charakterisierung des US-Schwingsystems 300 an. In einem weiteren Ausführungsbeispiel findet der Schritt 406 nach dem Schritt 405 statt.

In Schritt 407 wird Zustands des Ultraschallschweißprozesses basierend auf einem Referenzsignalverlauf und der ermittelten Signaleigenschaft durch die Auswerteeinrichtung 315 bestimmt. Hierzu wird der Referenzsignalverlauf als Sollwert vorgegeben und verglichen, ob die ermittelte Signaleigenschaft in einem vorbestimmten Bereich um den Sollwert herum liegt.

### Bezugszeichenliste

- 100: Ultraschallschweißanlage
- 101: Generator
- 103: Schwingerzeuger
- 105: Sonotrode
- 107: Schweißgut
- 201: Wagen
- 202: Umgebung
- 300: Ultraschallschweißanlage
- 301: Ultraschallgenerator
- 303: Ultraschallwerkzeug
- 305: Vorrichtung
- 307: Schaltelement
- 309: Relais
- 311: Signalgeber
- 313: Entladungsschaltelement
- 315: Auswerteeinheit
- 316: Sensoreinrichtung
- 317: Spannungsmesser
- 319: Stromwandler
- 400: Flussdiagramm
- 401-407: Verfahrensschritt
- mₘ: Masse
- cₘ: Feder
- dₘ: Dämpfer
- F: Kraft
- x: Verschiebung
- a: Übertrager
- Cp: Kapazität
- Rp: Verlustwiderstand
- U: Spannung
- Q: Ladung
- i: mechanische Schwingung

## Patentansprüche

1. Vorrichtung (305) zum Bestimmen eines Zustands eines Ultraschallschweißprozesses, welcher mittels eines Ultraschallwerkzeugs (303) durchführbar ist, umfassend
eine Sensoreinrichtung (316), die eingerichtet ist, ein elektrisches Ansteuersignal des Ultraschallwerkzeugs (303) zu erfassen;
eine Auswerteeinrichtung (315), die eingerichtet ist,
eine Signaleigenschaft des Ansteuersignals zu ermitteln; und
einen Zustand des Ultraschallschweißprozesses basierend auf einem Referenzsignalverlauf und der ermittelten Signaleigenschaft zu bestimmen;
einen ersten Anschluss, der eingerichtet ist, mit einem Ausgang eines Ultraschallgenerators verbunden zu werden;
einen zweiten Anschluss, der eingerichtet ist, mit einem Signaleingang des Ultraschallwerkzeug (303) verbunden zu werden;
einen Signalpfad, der den ersten Anschluss und den zweiten Anschluss elektrisch verbindet; wobei die Sensoreinrichtung (316) eingerichtet ist, das elektrische Ansteuersignal an dem Signalpfad nichtinvasiv zu messen;
und charakterisiert durch
ein Schaltelement (307), das in dem Signalpfad angeordnet ist und eingerichtet ist, den Signalpfad zu unterbrechen, um den ersten Anschluss von dem zweiten Anschluss elektrisch zu trennen; und
einen Signalgeber (311), der eingerichtet ist, ein Steuersignal für das Ultraschallwerkzeug (303) zu erzeugen und das Ultraschallwerkzeug (303) anzusteuern, wenn das Schaltelement (307) den Signalpfad unterbricht.

2. Vorrichtung (305) nach Anspruch 1, wobei die Sensoreinrichtung (316) einen Spannungsmesser (317) umfasst, um ein Spannungssignal zu messen und/oder einen Stromwandler (319) umfasst, um ein Stromsignal zu messen.

3. Vorrichtung (305) nach einem der vorherigen Ansprüche, wobei das Schaltelement (307) eingerichtet ist, den Signalpfad zu unterbrechen, wenn die Sensorvorrichtung (316) erfasst, dass der Ultraschallgenerator (301) kein Steuersignal an das Ultraschallwerkzeug (303) sendet.

4. Vorrichtung (305) nach einem der vorherigen Ansprüche, wobei der Signalgeber (311) eingerichtet ist, das Steuersignal für das Ultraschallwerkzeug (303) mittels einer Kleinsignalsteuerung zu erzeugen.

5. Vorrichtung (305) nach einem der vorherigen Ansprüche, wobei die Sensorvorrichtung (316) eingerichtet ist, ein elektrisches Signal an dem Signalpfad zu messen, während der Signalgeber der Vorrichtung (305) über den Signalpfad das Ultraschallwerkzeug (303) ansteuert.

6. Vorrichtung (305) nach Anspruch 5, wobei die Auswerteeinrichtung (315) eingerichtet ist, basierend auf dem gemessenen elektrischen Signal, das gemessen wurde, während der Signalgeber (311) der Vorrichtung (305) über den Signalpfad das Ultraschallwerkzeug (303) ansteuert, Ersatzparameter zu bestimmen.

7. Vorrichtung (305) nach einem der vorherigen Ansprüche, wobei der Signalgeber (311) eingerichtet ist, das Steuersignal basierend auf einem Betriebssignal des Ultraschallgenerators (301) zu erzeugen, insbesondere mit einer Frequenz zwischen ± 2 kHz der Betriebsfrequenz des Ultraschallgenerators (301).

8. Vorrichtung (305) nach einem der vorherigen Ansprüche, umfassend ein Entladungsschaltelement (313), das an dem Signalpfad elektrisch angeschlossen und eingerichtet ist, in einem leitenden Zustand das Ultraschallwerkzeug (303) kurzzuschließen, so dass eine Restladung im Ultraschallwerkzeug (303) abfließen kann.

9. Anordnung mit einer Ultraschallschweißanlage (300) und einer Vorrichtung (305) nach einem der Ansprüche 1 bis 8, wobei die Vorrichtung (305) zwischen einem Ultraschallgenerator (301) der Ultraschallschweißanlage (300) und einem Ultraschallwerkzeug (303) der Ultraschallschweißanlage (300) angeschlossen ist.

10. Verfahren zum Bestimmen eines Zustands eines Ultraschallschweißprozesses umfassend:
Messen (405) eines elektrischen Ansteuersignals eines Ultraschallwerkzeugs (303) durch eine Sensoreinrichtung (316);
Ermitteln (406) einer Signaleigenschaft des Ansteuersignals durch eine Auswerteeinrichtung (315);
Bestimmen (407) eines Zustands des Ultraschallschweißprozesses basierend auf einem Referenzsignalverlauf und der ermittelten Signaleigenschaft durch die Auswerteeinrichtung (315);
und charakterisiert durch die Schritte:
Trennen eines Ultraschallgenerators (301) von dem Ultraschallwerkzeug (303) durch ein Schaltelement (307); und
Erzeugen eines Steuersignals durch einen Signalgeber (311) und Ansteuern des Ultraschallwerkzeugs (303), wenn der Ultraschallgenerator (301) von dem Ultraschallwerkzeug (303) getrennt ist.

11. Verfahren nach Anspruch 10, umfassend ein Bestimmen eines Ersatzparameters für die Schweißanlage basierend auf einem bestimmten Zustand des Ultraschallschweißprozesses basierend auf dem erzeugten Steuersignal.

## Claims

1. Device (305) for determining a state of an ultrasonic welding process which can be performed by means of an ultrasonic tool (303), comprising
a sensor device (316) which is set up to detect an electrical actuation signal of the ultrasonic tool (303);
an evaluator (315), which is set up,
to determine a signal characteristic of the drive signal; and
to determine a state of the ultrasonic welding process based on a reference signal curve and the determined signal characteristic;
a first connection that is set up to be connected to an output of an ultrasonic generator;
a second connection which is set up to be connected to a signal input of the ultrasonic tool (303);
a signal path that electrically connects the first connection and the second connection;
wherein the sensor device (316) is set up to non-invasively measure the electrical actuation signal on the signal path;
and **characterized by**
a switching element (307) disposed in the signal path and adapted to interrupt the signal path to electrically isolate the first connection from the second connection; and
a signal generator (311) which is set up to generate a control signal for the ultrasonic tool (303) and to control the ultrasonic tool (303) when the switching element (307) interrupts the signal path.

2. Device (305) according to claim 1, wherein the sensor device (316) comprises a voltmeter (317) to measure a voltage signal and/or a transformer (319) to measure a current signal.

3. Device (305) according to one of the preceding claims, wherein the switching element (307) is arranged to interrupt the signal path when the sensor device (316) detects that the ultrasonic generator (301) does not send a control signal to the ultrasonic tool (303).

4. Device (305) according to one of the preceding claims, wherein the signal generator (311) is arranged to generate the control signal for the ultrasonic tool (303) by means of a small-signal control.

5. Device (305) according to any one of the preceding claims, wherein the sensor device (316) is arranged to measure an electrical signal on the signal path, while the signal transmitter of the device (305) controls the ultrasonic tool (303) via the signal path.

6. Device (305) according to claim 5, wherein the evaluator (315) is set up to determine substitute parameters based on the measured electrical signal that was measured while the signal generator (311) of the device (305) controls the ultrasonic tool (303) via the signal path.

7. Device (305) according to one of the previous claims, wherein the signal generator (311) is arranged to generate the control signal based on an operating signal of the ultrasonic generator (301), in particular with a frequency between ± 2 kHz of the operating frequency of the ultrasonic generator (301).

8. Device (305) according to one of the preceding claims, comprising a discharge switching element (313) which is electrically connected to the signal path and is arranged to short-circuit the ultrasonic tool (303) in a conductive state, so that a residual charge in the ultrasonic tool (303) can flow off.

9. Arrangement comprising an ultrasonic welding system (300) and a device (305) according to any one of claims 1 to 8, wherein the device (305) is connected between an ultrasonic generator (301) of the ultrasonic welding system (300) and an ultrasonic tool (303) of the ultrasonic welding system (300).

10. Method for determining a state of an ultrasonic welding process comprising:
Measurement (405) of an triggering signal of an ultrasonic tool (303) by a sensor device (316);
Determination (406) of a signal characteristic of the triggering signal by an evaluation device (315);
Determination (407) of a state of the ultrasonic welding process based on a reference signal curve and the determined signal characteristic by the evaluation device (315);
and **characterized by** the steps:
Disconnecting an ultrasonic generator (301) from the ultrasonic tool (303) by a switching element (307); and
Generation of a control signal by a signal generator (311) and actuation of the ultrasonic tool (303) when the ultrasonic generator (301) is separated from the ultrasonic tool (303).

11. Method according to claim 10, comprising determining an equivalent parameter for the welding system based on a specific state of the ultrasonic welding process based on the generated control signal.

## Revendications

1. Dispositif (305) pour déterminer un état d'un processus de soudage par ultrasons, qui peut être réalisé au moyen d'un outil à ultrasons (303), comprenant
un dispositif de détection (316) qui est adapté pour détecter un signal de commande électrique de l'outil à ultrasons (303) ;
un dispositif d'évaluation (315) qui est aménagé,
déterminer une caractéristique de signal du signal de commande ; et
déterminer un état du processus de soudage par ultrasons sur la base d'une courbe de signal de référence et de la caractéristique de signal déterminée ;
un premier connecteur adapté pour être connecté à une sortie d'un générateur d'ultrasons ;
un deuxième port adapté pour être connecté à une entrée de signal de l'outil ultrasonique (303) ;
un chemin de signal reliant électriquement la première borne et la deuxième borne ;
dans lequel le moyen de détection (316) est adapté pour mesurer de manière non invasive le signal d'entraînement électrique sur le chemin de signal ;
et **caractérisé par**
un élément de commutation (307) disposé dans le trajet de signal et adapté pour interrompre le trajet de signal afin d'isoler électriquement la première borne de la seconde borne ; et
un générateur de signaux (311) qui est conçu pour générer un signal de commande pour l'outil à ultrasons (303) et pour commander l'outil à ultrasons (303) lorsque l'élément de commutation (307) interrompt le trajet de signal.

2. Dispositif (305) selon la revendication 1, dans lequel le moyen de détection (316) comprend un voltmètre (317) pour mesurer un signal de tension et/ou comprend un transformateur de courant (319) pour mesurer un signal de courant.

3. Dispositif (305) selon l'une quelconque des revendications précédentes, dans lequel l'élément de commutation (307) est adapté pour interrompre le trajet du signal lorsque le dispositif de détection (316) détecte que le générateur d'ultrasons (301) n'envoie pas de signal de commande à l'outil à ultrasons (303).

4. Dispositif (305) selon l'une des revendications précédentes, dans lequel le générateur de signaux (311) est adapté pour générer le signal de commande pour l'outil à ultrasons (303) au moyen d'une commande à petits signaux.

5. Dispositif (305) selon l'une quelconque des revendications précédentes, dans lequel le dispositif de détection (316) est adapté pour mesurer un signal électrique sur le trajet de signal tandis que le générateur de signal du dispositif (305) commande l'outil ultrasonique (303) via le trajet de signal.

6. Dispositif (305) selon la revendication 5, dans lequel le dispositif d'évaluation (315) est agencé pour déterminer des paramètres de remplacement sur la base du signal électrique mesuré, qui a été mesuré pendant que le générateur de signaux (311) du dispositif (305) commande l'outil à ultrasons (303) via le trajet de signal.

7. Dispositif (305) selon l'une des revendications précédentes, dans lequel le générateur de signaux (311) est agencé pour générer le signal de commande sur la base d'un signal de fonctionnement du générateur d'ultrasons (301), notamment à une fréquence comprise entre ± 2 kHz de la fréquence de fonctionnement du générateur d'ultrasons (301).

8. Dispositif (305) selon l'une quelconque des revendications précédentes, comprenant un élément de commutation de décharge (313) connecté électriquement au trajet de signal et adapté pour court-circuiter l'outil à ultrasons (303) dans un état conducteur, de sorte qu'une charge résiduelle dans l'outil à ultrasons (303) peut s'écouler.

9. Ensemble comprenant une installation de soudage par ultrasons (300) et un dispositif (305) selon l'une quelconque des revendications 1 à 8, dans lequel le dispositif (305) est connecté entre un générateur d'ultrasons (301) de l'installation de soudage par ultrasons (300) et un outil à ultrasons (303) de l'installation de soudage par ultrasons (300).

10. Procédé de détermination d'un état d'un processus de soudage par ultrasons comprenant :
la mesure (405) d'un signal électrique de commande d'un outil à ultrasons (303) par un dispositif de détection (316) ;
détermination (406) d'une caractéristique de signal du signal de commande par un dispositif d'évaluation (315) ;
déterminer (407) un état du processus de soudage par ultrasons sur la base d'une courbe de signal de référence et de la caractéristique de signal déterminée par le dispositif d'évaluation (315) ;
et **caractérisé par** les étapes :
déconnecter un générateur d'ultrasons (301) de l'outil à ultrasons (303) par un élément de commutation (307) ; et
la génération d'un signal de commande par un générateur de signaux (311) et la commande de l'outil à ultrasons (303) lorsque le générateur d'ultrasons (301) est séparé de l'outil à ultrasons (303).

11. Procédé selon la revendication 10, comprenant la détermination d'un paramètre de remplacement pour l'équipement de soudage sur la base d'un état particulier du processus de soudage par ultrasons sur la base du signal de commande généré.
